Europäisches Patentamt

European Patent Office

Office européen des brevets

(11) Publication number: **0 616 362 A2**

## EUROPEAN PATENT APPLICATION

(21) Application number: **94103889.5**

(22) Date of filing: **14.03.94**

(51) Int. Cl.5: **H01L 21/461**

(30) Priority: **15.03.93 JP 53478/93**
**19.04.93 JP 90327/93**
**22.09.93 JP 235286/93**

(43) Date of publication of application:
**21.09.94 Bulletin 94/38**

(84) Designated Contracting States:
**DE FR GB NL**

(71) Applicant: **Kabushiki Kaisha Toshiba**
**72, Horikawa-cho**
**Saiwai-ku**
**Kawasaki-shi (JP)**

(72) Inventor: **Kojima, Katsuyoshi, c/o Intellectual**

Property Div.
**KABUSHIKI KAISHA TOSHIBA,**
**1-1, Shibaura 1-chome**
**Minato-ku, Tokyo 105 (JP)**
Inventor: **Murai, Seiichiro, c/o Intellectual**
**Property Div.**
**KABUSHIKI KAISHA TOSHIBA,**
**1-1, Shibaura 1-chome**
**Minato-ku, Tokyo 105 (JP)**

(74) Representative: **Blumbach Weser Bergen**
**Kramer Zwirner Hoffmann Patentanwälte**
**Radeckestrasse 43**
**D-81245 München (DE)**

(54) **Method for polishing work piece and apparatus therefor.**

(57) A method for polishing a wafer (1, 41) having a plurality of types of materials in a laminar state by polishing the wafer (1, 41) by a polishing cloth (17, 57). This method has the steps of receiving a signal regarding a temperature from the polishing cloth (17, 57) during polishing of the wafer (1, 41), processing the received signal (SA), detecting change point (T1, T2) of a temperature (T) of the polishing cloth (17, 57) based on the processed signal, and detecting an end point of processing based on the change point (T1, T2).

FIG. 1

EP 0 616 362 A2

The present invention relates to a method and an apparatus for polishing a semiconductor wafer or the like and, more particularly, to a method for polishing a work piece and an apparatus for polishing the work piece to detect an end point of the polishing by monitoring a thickness of the wafer during the polishing.

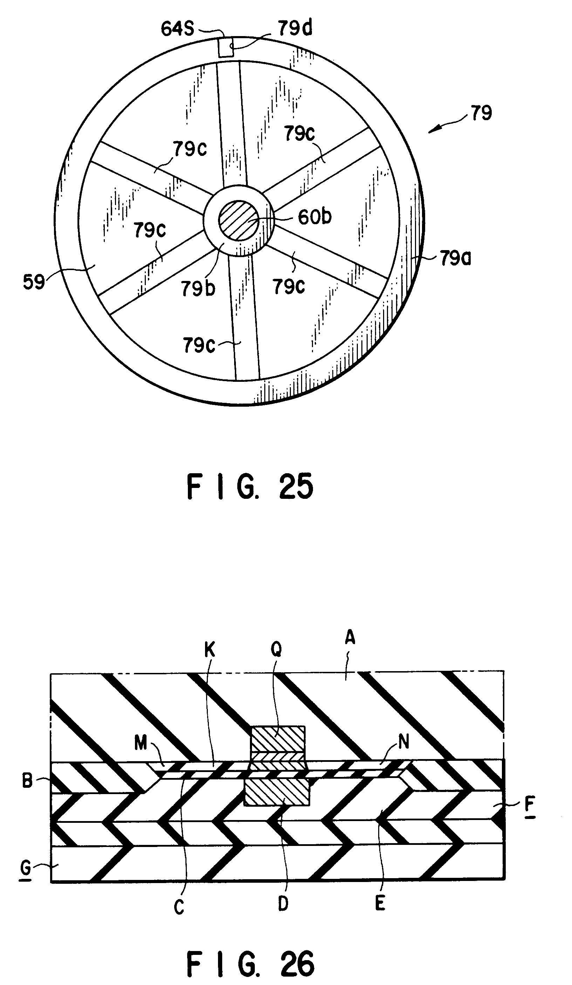

SOI (Silicon on Insulator) is expected for application to a high speed LSI because of features of radiation resistance, latchup resistance and low parasitic capacity. FIG. 26 shows a structure of a double gate MOS (Metal Oxide Semiconductor). Generally, the MOS is manufactured mainly through next six steps. That is, in step 1, a field oxide film B is arranged on a polycrystalline Si substrate A, and then a back gate oxide film C and a back gate electrode D are arranged by using ordinary gate forming technique. In step 2, a CVD (Chemical Vapor Deposition) oxide film E is deposited from the back gate oxide film C. In step 3, the CVD oxide film E is polished, and a step of the back gate is flatened. In step 4, a substrate F formed with the back gate and a support substrate G with BPSG (Boron-doped Phosphorus-Silicate Glass) are laminated by a pulse electrostatic bonding method. In step 5, the filed oxide film B is used as a stopper, the Si substrate A is ground and selectively polished, and a thin film Si portion K of a step of the field oxide film B is formed. In step 6, a source M, a drain N and a front gate Q of a front gate MOSFET are formed on the thin film Si portion K by an ordinary process.

A thickness of a wafer is normally reduced from 625 $\mu$m to about 400 $\mu$m by the selective polishing of the Si in the step 5. However, since a detection of an end point of the selective polishing is difficult, there arises a problem that overpolishing frequently occurs. A recess is produced on the thin film Si portion K by the overpolishing to disturb an improvement in a manufacturing yield.

Therefore, the end point of the processing has been detected by managing a processing time to certain degree and then visually observing it for each short time. Thus, it not only deteriorates its efficiency but there is a large margin to cause a detecting error of the end point the processing. On the other hand, it is also considered to measure a thickness of a wafer by an optical method or an electric capacity method and to detect the end point of processing from the measured result. However, if a surface to be measured is contaminated with processing solution, a measuring error occurs, and hence it is not adapted for an on-machine•in-process measurement. A method for detecting an end point of processing by measuring a thickness of a wafer by an ultrasonic wave method is insufficiently accurate.

Therefore, a conventional apparatus for detecting an end point of processing with selective polishing to be executed in an SOI manufacturing process is insufficient at the points of detecting accuracy and efficiency.

Accordingly, it is a primary object of the present invention to provide a method for detecting an end point of processing and an apparatus for executing the same in which a detection of an end point of processing of selective polishing can be accurately conducted in process.

According to the present invention, there is provided a method for polishing a work piece having a plurality of types of materials laminated in a laminar state by polishing means comprising the steps of receiving a signal regarding a temperature at least from one of the work piece and the polishing means during polishing of the work piece, processing the received signal, detecting a change point of at least one temperature of the work piece and the polishing means based on the processed signal, and detecting an end point of polishing based on the change points.

According to this method, a polishing amount can be severely controlled. As a result, when the method is applied, for example, to an ultrahigh precision polishing process for an ultrathin film SOI or the like necessary for a high speed MOS, a processing efficiency, a yield and reliability can be remarkably improved.

Since a polishing apparatus for executing the method comprises a process end point detector, the apparatus can automatically accurately detect an end point of polishing, and can severely control a polishing amount. Therefore, when the polishing apparatus of the present invention is applied, for example, to an ultra-high precision polishing process for an ultrathin film SOI or the like necessary for a high speed MOS, its yield, reliability and throughput can be significantly improved.

Further, according to the present invention, there are provided a method and an apparatus for polishing a work piece by detecting an end point of polishing based on a variation in a vibration mode due to a change of a structure of a material to be polished and stopping the polishing in a surface grinding of the work piece made of a plurality of types of materials having different vibration modes.

According to this method, a polishing amount can be severely controlled. As a result, when the method is applied, for example, to an ultrahigh precision polishing process for an ultrathin film SOI or the like necessary for a high speed MOS, processing efficiency, yield and reliability can be remarkably improved.

Since the polishing apparatus of the present invention comprises a process end point detector, automatic detection of an end point of polishing can be accurately conducted, and a polishing amount can be severely controlled. Therefore, when the polishing apparatus of the present invention is applied, for example, to an ultrahigh precision polishing process for an ultrathin film SOI or the like necessary for a high speed MOS, yield of the material, reliability of a product can be significantly improved.

This invention can be more fully understood from the following detailed description when taken in conjunction with the accompanying drawings, in which:

FIG. 1 is a view of an entire structure of an a polishing apparatus according to an embodiment of the present invention;

FIG. 2 is a sectional view of a work piece to be polished by the polishing apparatus according to the embodiment of the present invention;

FIGS. 3A to 3C are flow charts showing an example of a method for polishing a work piece by the polishing apparatus of FIG. 1;

FIG. 4 is a graph showing the relationship between a polishing temperature and a polishing time for explaining the embodiment of the invention;

FIG. 5 is a graph showing differential coefficients of the polishing temperature and the polishing time for explaining the embodiment of the invention;

FIG. 6 is a sectional view of a work piece for explaining a polishing state of the work piece;

FIG. 7 is an explanatory view of a modified example of the polishing apparatus of FIG. 1;

FIG. 8 is an explanatory view of another modified example of the invention;

FIG. 9 is a sectional view of a work piece to be polished by a method for polishing the work piece according to another embodiment of the present invention;

FIG. 10 is a graph showing the relationship between a polishing temperature and a polishing time for explaining a method for polishing a work piece according to yet another embodiment relative to FIG. 9;

FIG. 11 is a sectional view of a work piece to be polished by a method for polishing a work piece according to still another embodiment of the present invention;

FIG. 12 is a graph showing the relationship between a polishing temperature and a polishing time for explaining a method for polishing a work piece according to still another embodiment relative to FIG. 11;

FIG. 13 is a view of an entire structure of a polishing apparatus according to still another embodiment by using a vibration sensor;

FIG. 14 is a graph showing a time change of the vibration for explaining a method for polishing a work piece relative to the polishing apparatus of FIG. 13;

FIG. 15 is a graph showing a power spectrum for explaining the method for polishing the work piece relative to FIG. 13;

FIG. 16 is a sectional view of a work piece for explaining a method for polishing a work piece according to still another embodiment of the present invention;

FIG. 17 is a graph showing a time change of a vibration for explaining the method for polishing the work piece according to the one embodiment of the present invention;

FIG. 18 is a graph showing a power spectrum for explaining the method for polishing the work piece according to the one embodiment of the present invention;

FIG. 19 is a sectional view of a main portion of a work piece for explaining the method for polishing the work piece according to the one embodiment of the present invention;

FIG. 20 is a graph showing a power spectrum for explaining the method for polishing the work piece according to the another embodiment of the present invention;

FIG. 21 is a graph showing a power spectrum for explaining the method for polishing the work piece according to the another embodiment of the present invention;

FIG. 22 is a view of a structure of the polishing apparatus according to the another embodiment of the present invention;

FIG. 23 is an enlarged plan view of a sensor mounting jig of the polishing apparatus shown in FIG. 22;

FIG. 24 is a graph showing the relationship between a distortion amount and a processing time for explaining the method for polishing the work piece according to the another embodiment of the present invention using the polishing apparatus shown in FIG. 22;

FIG. 25 is an enlarged plan view showing a modified example of a sensor mounting jig of the polishing apparatus shown in FIG. 22; and

FIG. 26 is an explanatory view for explaining manufacturing steps according to prior art.

The present invention will be described with reference to a first embodiment shown in the accompanying drawings.

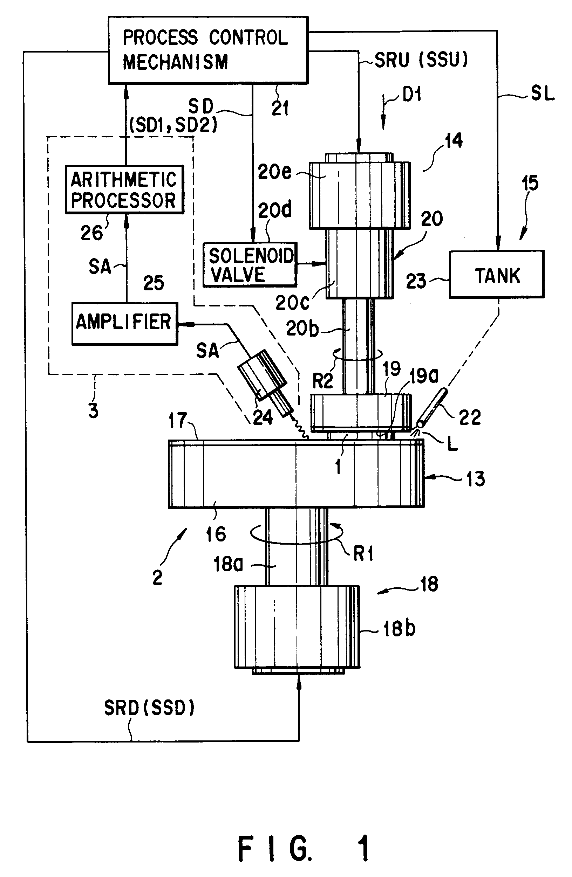

FIG. 1 shows a polishing apparatus of this embodiment. The polishing apparatus has a polishing unit 2 for surface grinding a work piece 1 to become an SOI, and a processing end point detector 3 for detecting an end point of processing the work piece 1 polished by the polishing unit 2.

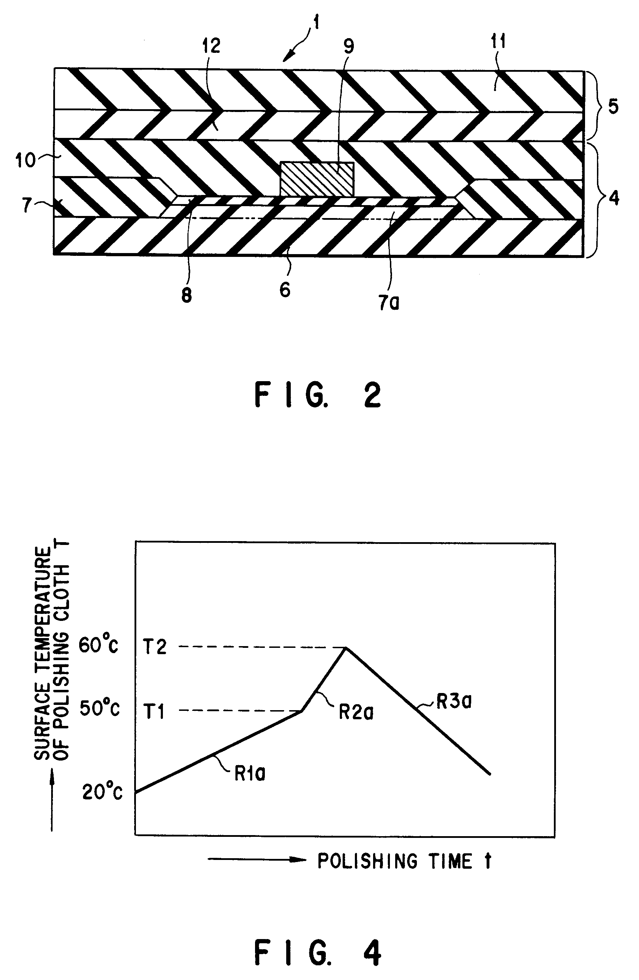

FIG. 2 shows a structure of the work piece 1 before processing. As shown in FIG. 2, the work piece 1 has a laminated structure of a first substrate portion 4 and a second substrate portion 5 laminated to the first substrate portion 4, for example, by a pulse electrostatically adhering method. The first substrate portion 4 has an Si thin film 6 made of polycrystalline Si, a field oxide film 7 made of $SiO_2$ deposited on the Si thin film 6, a back gate oxide film 8 arranged in an opening 7a of the field oxide film 7, a back gate electrode 9 arranged on the back gate oxide film 8, and a $CVD-SiO_2$ film 10 covering the entire surface of the Si thin film 6 at the side of the back gate electrode 6. The back gate oxide film 8 is arranged in parallel with the surface of the substrate portion at a central portion in its depth direction in the opening 7a of the field oxide film 7, and portions of the $CVD-SiO_2$ film 10 and the Si thin film 6 are filled therein at both sides of the back gate oxide film 8. The second substrate portion 5 comprises a support substrate 11, and a BPSG film 12 arranged on the support substrate 11. The first substrate portion 4 is integrally connected to the second substrate 5 by adhering the BPSG film 12 to the $CVD-SiO_2$ film 10. The work piece 1 of this embodiment is surface ground at the Si thin film 6 until the field oxide film 7 is exposed (a region indicated by an imaginary line in FIG. 2).

As shown in FIG. 1, the polishing unit 2 for grinding the work piece 1 has a lower surface plate section 13, an upper surface plate section 14 arranged at an upper position oppositely to the lower surface plate 13, and a process control mechanism 21 for electrically controlling the lower surface plate 13 and the upper surface plate 14. The polishing unit 2 of this embodiment is supplied with processing solution L from a liquid supply unit 15 to a position to be polished at the work piece 1.

The lower surface plate section 13 has a lower surface plate 16 formed in a disc, a polishing cloth 17 adhered to the lower surface plate 16 and made, for example, of foamed urethane, and a lower surface plate driving mechanism 18 for holding and rotatably driving the lower surface plate 16. The lower surface plate driving mechanism 18 has a holding shaft 18a coaxially coupled to a lower surface of the lower surface plate 16, and a lower surface plate driving motor 18b for supporting and rotatably driving the holding shaft 18a.

The upper surface plate section 14 has an upper surface plate 19 having a diameter smaller than a radius of the lower surface plate 16, and an upper surface plate driving mechanism 20 for supporting, rotatably driving the upper surface plate 19 and pressurizing the upper surface plate 19 to the lower surface plate 16. A polyurethane suction sheet 19a (not shown) for detachably holding the work piece 1 is mounted on a lower surface of the upper surface plate 19. The upper surface plate driving mechanism 20 has a holding shaft 20b coaxially coupled to the upper surface plate 19 on a back of the upper surface plate 19, pressurizing means 20c such as, for example, a pneumatic cylinder detachably attached at an upper end of the holding shaft 20b for vertically driving the holding shaft 20b, a solenoid valve 20d for controlling application of pneumatic pressure to the pressurizing means 20c, and an upper surface plate driving motor 20e for holding the upper end of the pressurizing means 20c and rotatably driving it around an axis.

The liquid supply unit 15 has a nozzle 22 for injecting processing solution L containing free abrasive to a position to be polished, and a tank 23 for storing the processing solution L to be supplied to the nozzle 22. The processing solution L can be suitably selected in response to a material of the layer to be polished. In this embodiment, the processing solution L contains, for example, colloidal silica and amine. This is mainly because the Si thin film 6 to be polished has small resistance against weak alkaline polishing solution and a hydrate is produced.

The processing end point detecting unit 3 has a radiation temperature sensor 24 such as, for example, an infrared thermometer arranged oppositely at a predetermined distance to the polishing cloth 17 of the lower surface plate 16 for detecting a surface temperature T of the polishing cloth 17 during polishing, an amplifier 25 for amplifying an electric signal ST indicating the surface temperature T of the polishing cloth 17 output from the radiation temperature sensor 24, and an arithmetic processor 26 inputting the electric signal ST output from the amplifier 25 for calculating the relationship between the surface temperature T of the polishing cloth 17 and the polishing time t based on the electric signal ST.

The processing control mechanism 21 has a solenoid valve 20d, an upper surface plate driving motor 20e, and a lower surface plate driving motor 18b, and is so provided as to be electrically connected to the liquid supply unit 15 and the arithmetic processor 26 to control polishing process as will be described later.

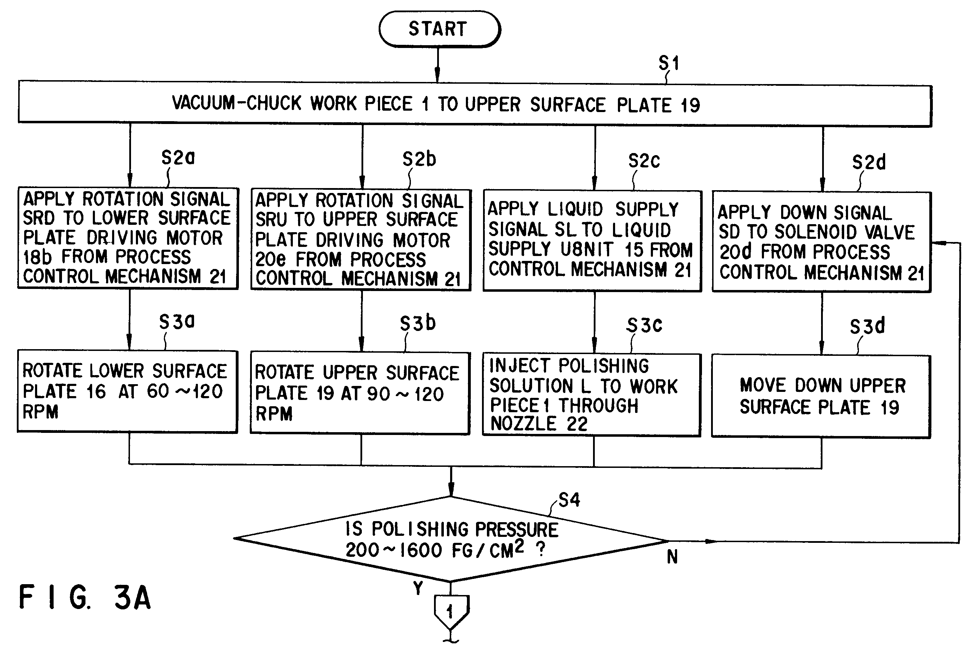

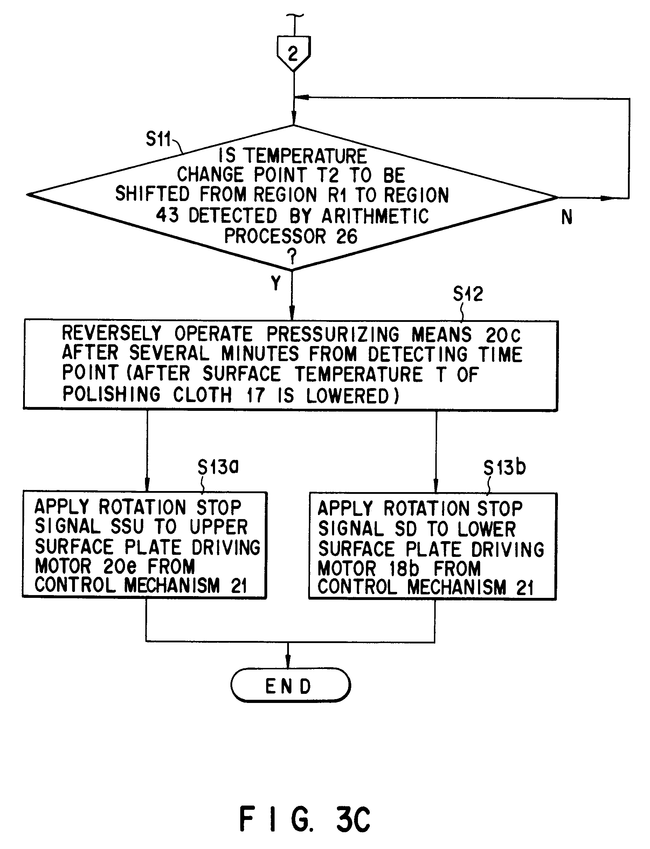

Then, a method for polishing the work piece 1 by the above-described polishing apparatus will be described with reference to FIGS. 3A to 3C.

First, the work piece 1 is so vacuum-chucked to the upper surface plate 19 that the Si thin film 6 is opposed to the polishing cloth 17 (step S1). Then, the lower surface plate 16 and the upper surface plate 19 are rotated, the processing solution L is injected to a position to be polished of the work piece 1, and the upper surface plate 19 is moved down. That is, a rotation signal SRD is applied from the process control mechanism 21 to the lower surface driving motor 18b (step S2a), and the lower surface plate 16 is rotated in a direction of an arrow R1, for example at about 60 to 120 rpm (step S3a). A rotation signal SRU is applied from the process control mechanism 21 to the upper surface plate driving motor 20e (step S2b), and the upper surface plate 19 is rotated in a direction of an arrow R2, for example, at about 60 to 120 rpm (step S3b). Further, a liquid supply signal SL is applied from the process control mechanism 21 to the liquid supply unit 15 (step S2c), and the processing solution L is injected to the position to be polished of the work piece 1 through the nozzle 22 (step S3c). A down signal SD is applied to the solenoid valve 20d (step S2d), and the upper surface plate 19 is moved down in a direction of an arrow D (step S3d). When the upper surface plate 19 is moved down, the Si thin film 6 of the work piece 1 is contacted with the polishing cloth 17. The process control mechanism 21 monitors a pressure of contacting the Si thin film 6 with the polishing cloth 17, i.e., a polishing pressure (step 4), and stops falling of the upper surface plate 19 when the polishing pressure becomes about 200 to 1,600 gf/cm$^2$.

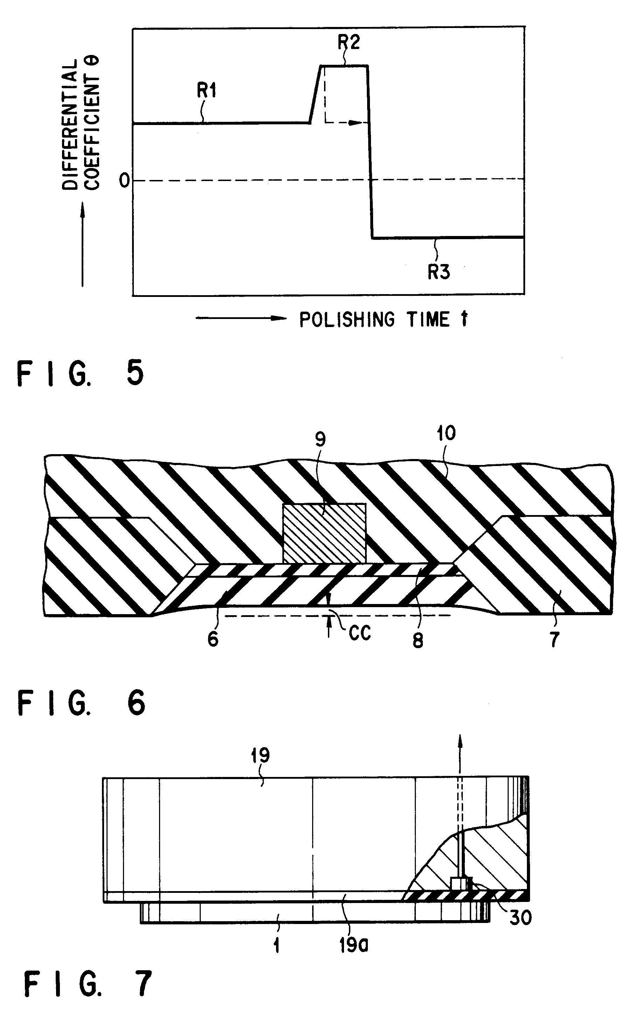

As described above, the Si thin film 6 is surface ground by the free abrasive contained in the processing solution L and the polishing cloth 17. At this time, the polishing cloth 17 is gradually raised at its surface temperature T by means of frictional heat of the work piece 1 and reaction heat of the Si thin film 5 with amine of the solution L as the polishing is advanced (see FIG. 4).

The radiation temperature sensor 24 receives an infrared light to be radiated from the polishing cloth 17, detects the surface temperature T of the polishing cloth 17, and converts it into an electric signal ST (step S0). This electric signal ST is sent to the amplifier 25, amplified by the amplifier 25 (step S6), and sent to the arithmetic processor 26. The arithmetic processor 26 calculates a differential coefficient $\theta$ ( = dT/dt) of the surface temperature T to the polishing time t (step S7).

FIG. 5 schematically shows the relationship between the differential coefficient $\theta$ and the polishing time t. In FIG. 5, a region R1 indicates the differential coefficient $\theta$ when only the Si thin film 6 is polished. The region R1 corresponds to a region R1a in FIG. 4, and it is understood that the surface temperature of the polishing cloth 17 is increased substantially at a constant rate. On the other hand, when the polishing of the Si thin film 6 is advanced, the field oxide film 7 is exposed and becomes immediately before it is contacted with the polishing cloth 17, the differential coefficient $\theta$ becomes a region R2 in FIG. 5. That is, as shown by a region R2a in FIG. 4 corresponding to the region R2, the increasing rate of the surface temperature T of the polishing cloth 17 is increased as compared with the initial polishing of the Si thin film 6. This is considered that the quantity of generated heat is increased due to an increase in denseness of a portion of an intermediate layer or more as compared with the initial layer of the Si thin film 6. Then, when the polishing of the Si thin film 6 is advanced and the field oxide film 7 is polished together with the Si thin film 6, the differential coefficient $\theta$ becomes a negative value as in a region R3 in FIG. 5. That is, as shown by the region R3a in FIG. 4 corresponding to the region R3, the surface temperature T of the polishing cloth 17 is gradually lowered as the polishing is advanced. This is considered that frictional coefficients of the field oxide film 7 and the polishing cloth 17 are much smaller than those of the Si thin film 6 and the polishing cloth 17 and, since the field oxide film 7 has larger resistance and is hard to react against the amine than the Si thin film 6, reaction heat is not almost generated.

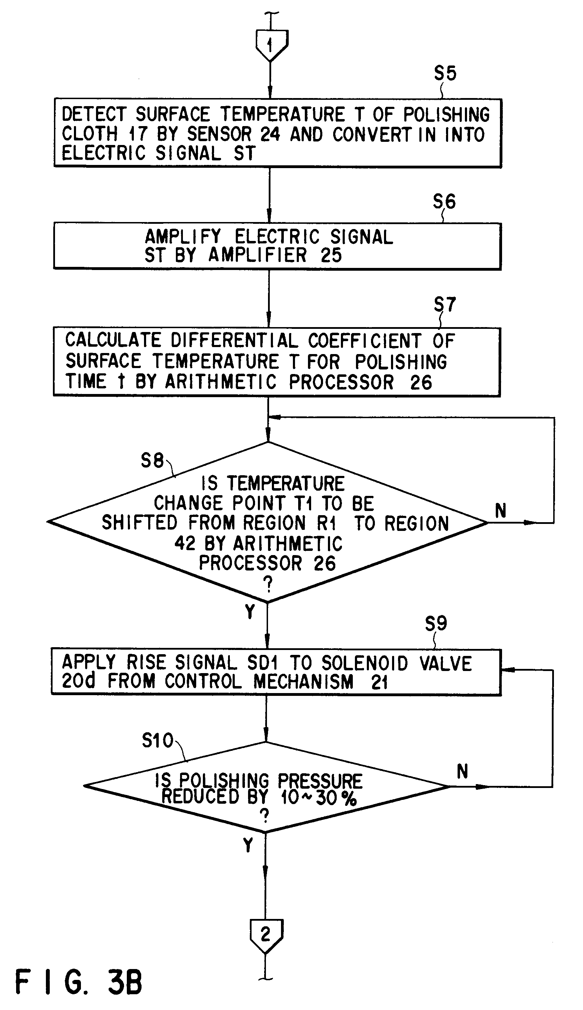

As shown in FIG. 3B, according to this embodiment, a temperature change point T1 in FIG. 4 from the region R1 to the region R2 is detected by the arithmetic processor 26 (step S8), the process control mechanism 21 applies a rise signal SD1 to the solenoid valve 20d when the temperature change point T1 is detected (step S9), and a polishing pressure of the upper surface plate 19 to the polishing cloth 17 is reduced, for example, by 10 to 30% (step S10). Thus, as shown in Figs. 4 and 5, the differential coefficient $\theta$ is corrected to the region R1 level. As a result, overheating of the work piece 1 can be prevented. Then, the arithmetic processor 26 detects a temperature change point T2 in FIG. 4 to be shifted from the region R2 to the region R3 (step S11), and applies a rise signal SD2 to the solenoid valve 20d after several minutes from a detecting time point (or after the surface temperature T of the polishing cloth 17 is lowered), thereby operating the pressurizing means 20c reversely (step S12).

As described above, the work piece 1 adhered to the upper surface plate 19 through the holding shaft 20b is peeled from the polishing cloth 17 adhered to the lower surface plate 16. Then, rotation stop signals SSU, SSD are respectively applied to the upper surface plate driving motor 20e and the lower surface plate driving motor 18b (step S13a, S13b) to finish the polishing.

As mentioned above, according to this embodiment, the processing end point detecting unit 3 is provided, and the polishing is controlled based on the detection result of the process end point detecting unit 3. Therefore, a sag (recess) CC (see FIG. 6) of the opening 7a of the field oxide film 7 can be reduced to 1 $\mu$m or less, and the work piece 1 can be efficiently polished. Particularly, since the temperature change point T1 is detected in the step S8 thereby to reduce the polishing pressure of the upper surface plate 19 to the polishing cloth 17, overheat of the work piece 1 can be prevented, thereby further enhancing the sag (recess) suppressing effect.

In the embodiment described above, the polishing pressure is regulated based on the temperature change point T1 to be shifted from the region R1 to the region R2 as detected. However, the present invention is not limited to the particular embodiment. For example, the process is omitted, and an end point of polishing may be merely detected by the temperature change point T2. In this case, the above-described steps S8 to S10 are omitted.

Further, in the embodiment described above, the processing end point is detected based on a decrease in the surface temperature of the polishing cloth 17 when the polishing is shifted from the Si thin film 6 to the field oxide film 7. However, the present invention is not limited to the particular embodiment. For example, the surface temperature of the polishing cloth might be raised when the polishing is shifted from a certain layer to its adjacent layer. The present invention may also be applied to the polishing of such a material.

In addition, in the embodiment described above, the type in which the surface temperature T of the polishing cloth 17 is detected by the radiation temperature sensor 24 has been employed. However, as shown in FIG. 7, a temperature sensor 30 such as, for example, a thermocouple is so buried in the upper surface plate 19 as to be contacted with the rear surface of the adsorption sheet 19a, and a temperature change of the rear surface of the work piece 1 may be directly detected.

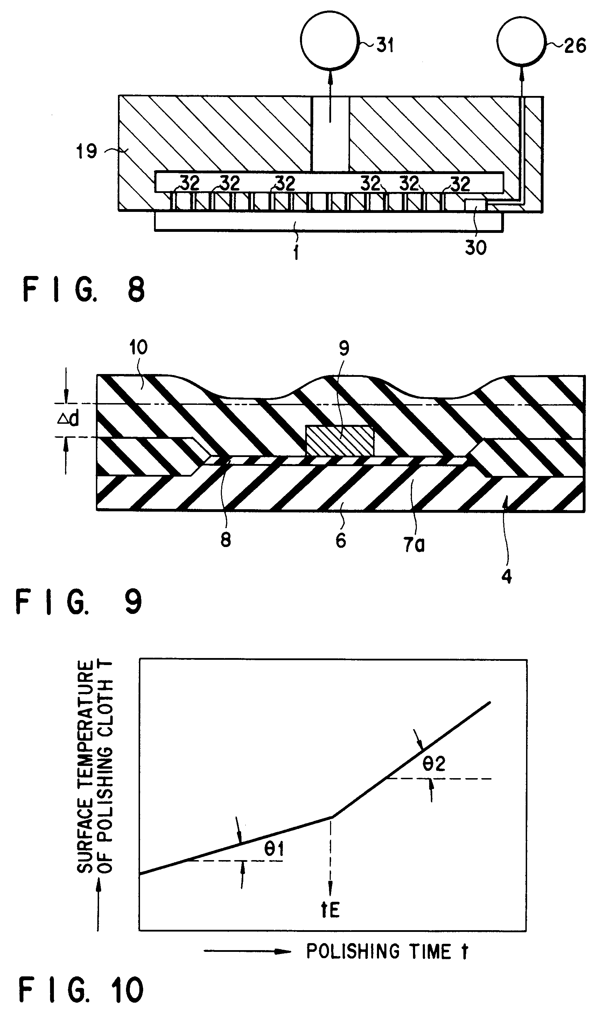

As shown in FIG. 8, when a vacuum chuck having a number of suction holes 32 to be connected to a vacuum source 31 is employed as the upper surface plate 19 and a temperature sensor 30 such as, for example, a thermocouple is buried in a chuck surface in which the suction holes 32 of the vacuum chuck are opened, a temperature change of the rear surface of the work piece 1 can be more accurately detected.

Further, the present invention is not limited to the steps of grinding and selectively polishing the Si substrate with the field oxide film as a stopper as in the above-described embodiment of the SOI manufacturing process. For example, the present invention may also be applied to a detection of an end point of the polishing step for flattening a step due to the back gate electrode 9 by polishing, for example, the CVD-SiO$_2$ film 10.

More specifically, as shown in FIG. 9, immediately after the field oxide film 7, the back gate oxide film 8 formed in the opening 7a of the field oxide film 7 and the back gate electrode 9 formed on the back gate oxide 8 are covered with the CVD-SiO$_2$ film 10, ruggedness corresponding to the protrusion of the back gate electrode 9 and the recess of the back gate oxide film 9 is formed on the surface of the CVD-SiO$_2$ film 10. Then, it is necessary to polish to remove the ruggedness and to flatten it. However, in this case, as shown in FIG. 9, it is necessary to detect an end point of polishing so that a thickness $\Delta d$ becomes constant (10 $\mu$m or less).

FIG. 10 shows the relationship between a polishing time t and a surface temperature T of the polishing cloth 17 when the surface of the CVD-SiO$_2$ film 10 is polished to remove the ruggedness. In this case, a temperature gradient $\theta2$ at the latter period of the polishing becomes remarkably larger than a temperature gradient $\theta1$ at the initial of the polishing. In other words, the quantity of generated heat upon polishing is remarkably increased at the latter period of polishing as compared with that at the initial of polishing. This is considered as causes thereof that, since the surface of the CVD-SiO$_2$ film 10 has ruggedness at the initial of polishing (see FIG. 9), the contact area of the CVD-SiO$_2$ film 10 with the polishing cloth 17 is small, but when the surface of the CVD-SiO$_2$ film 10 is completely flattened by the polishing, the contact area of the CVD-SiO$_2$ film 10 with the polishing cloth 17 is increased as compared with that at the initial of polishing to increase its frictional resistance thereby to cause the quantity of generated heat to be increased. Then, in the embodiment, the differential coefficient $\theta$ ( = dT/dt) of the surface temperature T to the polishing time t is calculated similarly to the embodiment described above, and the polishing is finished at a time point tE (see FIG. 10) in which the differential coefficient $\theta$ becomes a thickness $\Delta d$ varied from $\theta1$ to $\theta2$ 82.

Even in the embodiment as described above, the end point of polishing can be accurately detected, and hence particular effect that the thickness $\Delta d$ can be severely controlled as the CVD-SiO$_2$ film 10 is flattened is provided.

Incidentally, the end of polishing may be delayed by a predetermined time $\Delta t$ from the time point tE. Further, in view of the fact that the increased amount of the differential coefficient $\theta$ is increased as compared with that at the initial of polishing when the temperature gradient is not linearly varied at the time point of finishing the polishing to become the thickness $\Delta d$, the polishing may be finished at the time point when the differential coefficient $\theta$ exceeds a preset threshold value $\theta T$.

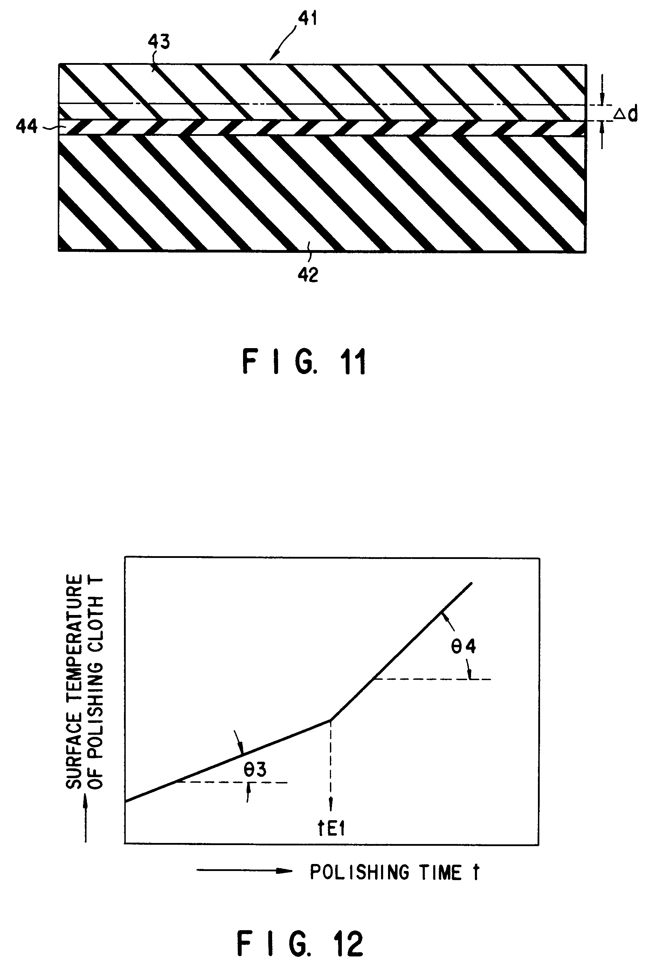

Further, the present invention is not limited to the structure of the work piece 1 of the above-described embodiment in the case of polishing the work piece formed by laminating a plurality of different materials in a laminar state in a cutout direction. For example, the present invention may be applied to polishing for flattening a work piece 41 as shown in FIG. 11. That is, this work piece 41 has an Si base substrate 42, a bond substrate (made of Si) 43 fixed to the base substrate 42 and being, for example, 20 $\mu$m thick, and an SiO$_2$ layer 44 inserted between the base substrate 42 and the bond substrate 43 and having a thickness of, for example, 1 $\mu$m. In this embodiment, an end point in which its thickness $\Delta$d1 becomes 2 $\mu$m is detected during polishing of the bond substrate 43 (which is conducted to obtain an active layer for forming a device).

More specifically, FIG. 12 shows the relationship between a polishing time t and a surface temperature T of the polishing cloth 17. In this case, a temperature gradient $\Theta$4 at the latter period of polishing is remarkably increased as compared with a temperature gradient 83 of the initial of polishing. In other words, the quantity of generated heat is remarkably increased upon polishing at the latter period of polishing as compared with that at the initial of polishing. It is considered as a cause that a heat transfer rate of the SiO2 layer 44 is much lower than that of the bond substrate 43. That is, since the generated polishing heat is substantially uniformly dissipated all around at the initial of polishing, a rise of the temperature T is smooth, but at the latter period of polishing, since it approaches the SiO$_2$ layer 44, the quantity of generated heat is stored in the SiO$_2$ layer 44 having a low heat transfer rate, and a temperature gradient at the latter period of polishing is resultantly abruptly increased. Then, in this embodiment, similarly to the embodiment described above, a differential coefficient $\theta$ ( = dT/dt) of a surface temperature T to a polishing time t is calculated, and the polishing is finished at a time point tE2 (see FIG. 12) in which the differential coefficient $\theta$ becomes a thickness $\Delta$d varied from $\Theta$3 to $\Theta$4.

Even in this embodiment as described above, an end point of polishing can be accurately detected, and hence particular effect that the thickness $\Delta$d1 can be severely controlled as the bond substrate 43 is flattened can be provided.

Incidentally, the end of polishing may be delayed by a predetermined time $\Delta$t1 to the time point tE1. In view of the fact that the increased amount of the differential coefficient $\theta$ becomes larger than that at the initial of polishing if the temperature gradient is not linearly varied at the time point of finishing the polishing to become the thickness $\Delta$d1, the polishing may be finished at a time point when the differential coefficient $\theta$ exceeds a preset threshold value 8T1.

Further, the method and apparatus for polishing the work piece described above are not limited to the surface grinding as described above, but may be applied to other polishing process such as a curved surface processing, a groove processing.

Moreover, the above-described embodiment exemplifies ordinary polishing. However, the present invention may also be applied to mechanical・chemical polishing (CMP), mechanochemical polishing, etc.

In the embodiments described above, the polishing is exemplified as the type of polishing. However, the present invention may also be applied to all processing methods in the case of lapping, grinding, surface grinding. Of course, the present invention may also be applied to one side polishing and both-side polishing.

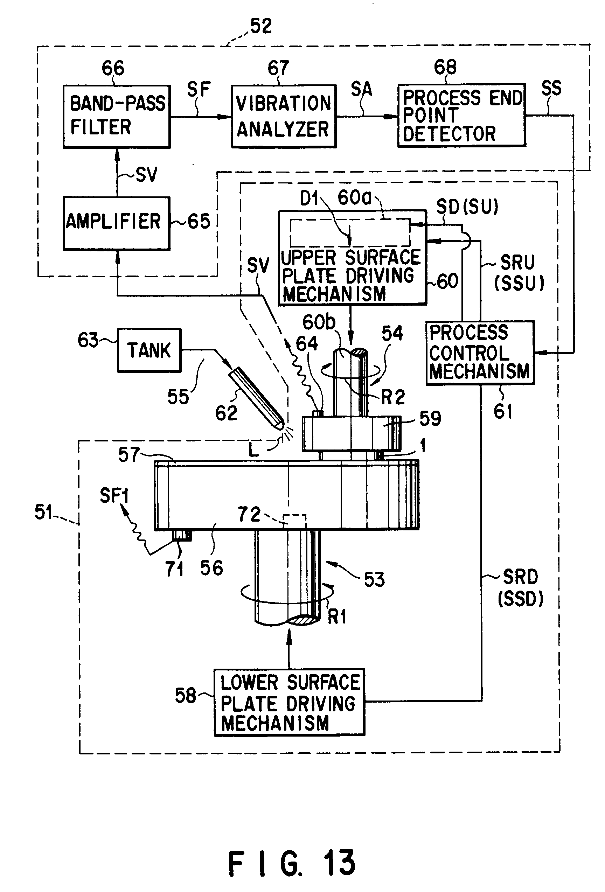

FIG. 13 shows a polishing apparatus according to another embodiment of the present invention. This polishing apparatus has a polishing unit 51 for surface grinding a thin plate-shaped work piece 1 to become an SOI, and a processing end point detector 52 for detecting an end point of processing the work piece 1 surface ground by the polishing unit 51. The work piece 1 to be polished by the polishing apparatus is similar to that shown in FIG. 2, and a detailed description thereof will be omitted.

As shown in FIG. 13, the polishing unit 51 has a lower surface plate section 53, an upper surface plate section 54 arranged at an upper position oppositely to the lower surface plate 53, and a process control mechanism 61 for electrically controlling the lower surface plate 53 and the upper surface plate 54. The polishing unit 51 of this embodiment is supplied with processing solution L from a liquid supply unit 55 to a position to be polished at the work piece 1. The lower surface plate section 53 has a lower surface plate 56 formed in a disc, a polishing cloth 57 adhered to the lower surface plate 56 and made, for example, of foamed urethane, and a lower surface plate driving mechanism 58 for holding and rotatably driving the lower surface plate 56. The upper surface plate driving mechanism 60 and the lower surface plate driving mechanism 58 are electrically controlled by the above-described process control mechanism 61.

The upper surface plate driving mechanism 60 has elevation means 60a such as, for example, a pneumatic cylinder for vertically moving the upper surface plate 59 through a shaft 60b. The liquid supply unit 55 has a nozzle 62 for injecting processing solution L containing free abrasive to a position to be polished, and a tank 63 for storing the processing solution L to be supplied to the nozzle 62. The processing solution L can be suitably selected in response to a material of the layer to be polished. In this embodiment, the processing solution L contains, for example, colloidal silica and amine. This is mainly because the Si thin film 6 to be polished has small resistance against weak alkaline polishing solution.

The processing end point detecting unit 60 has a vibration sensor 64 such as, for example, a semiconductor gage type (or a piezoelectric type or a strain gage type) acceleration pickup, a cantilever with a strain gage attached to a back surface of the upper surface plate 59, an amplifier 65 for amplifying a vibration detection signal SV output from the vibration sensor 65, a band-pass filter 66 for extracting only a frequency component necessary to detect a process end point of the vibration detection signal SV amplified by the amplifier 65, a vibration analyzer 67 inputting the vibration detection signal SF having only a necessary frequency component output from the band-pass filter 66 for analyzing a vibration to be described later, and a process end point detector 68 inputting an analysis signal A in the vibration analyser 67 for detecting a process end point to output a process stop signal SS to the process control mechanism 61. Transmission of a signal from the vibration sensor 64 to the amplifier 65 is so provided as to be conducted by a radio type, and both have antennas for receiving and transmitting the signal. It should be noted that the signal maybe transmitted from the vibration sensor 64 to the amplifier by way of a wired signal line (not shown). The band-pass filter 66 is so set as to pass only a vibration detection signal SV of a frequency band of, e.g., 2kHz to 4kHz.

Further, the vibration analyzer 67 is of an FFT (Fast Fourier Transform) type vibration analyzer to output an analysis signal SA indicating a power spectrum of the frequency band of, e.g., 2kHz - 4kHz. Further, the process end point detector 68 is set with a threshold value PT, and so set as to output a process stop signal SS to the process control mechanism 61 if the analysis signal SA output from the vibration analyzer 67 exceeds the threshold value PT.

Then, a method for polishing the work piece 1 by the above-described polishing apparatus will be described.

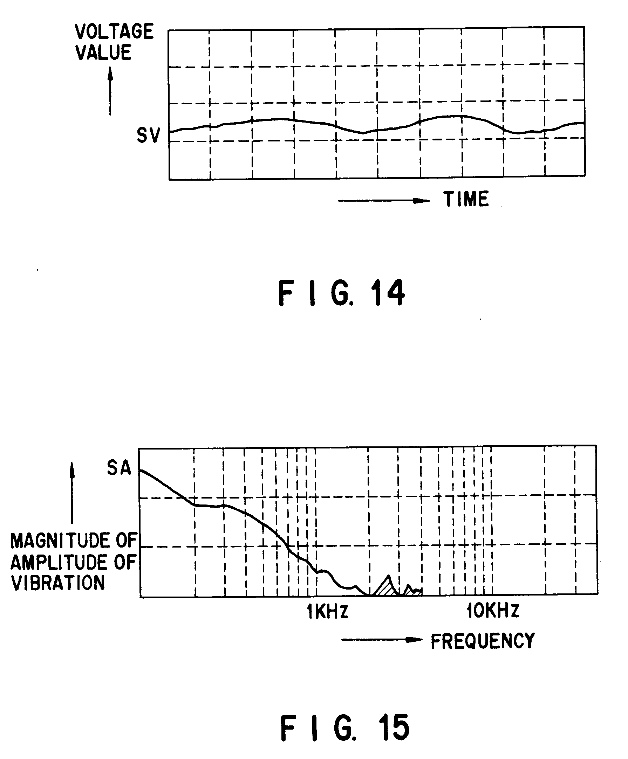

First, the work piece 1 is so adhered to the upper surface plate 59 that the Si thin film 6 is opposed to the polishing cloth 57. Then, a rotation signal SRD is applied from the process control mechanism 61 to the lower surface plate driving mechanism 58, and the lower surface plate 56 is rotated in a direction of an arrow R1, for example at about 60 to 120 rpm. Then, a rotation signal SRU and a down signal SD are applied from the process control mechanism 61 to the upper surface plate driving mechanism 60 and the upper surface plate 59 is rotated in a direction of an arrow R2, for example, at about 60 to 120 rpm, and the upper surface plate 59 is moved down in a direction of an arrow R2, and the Si thin film 6 of the work piece 1 is contacted with the polishing cloth 17. The upper surface plate 59 is moved down and stopped in the state that the polishing pressure becomes about 200 to 600 $gf/cm^2$. In this case, the processing solution L is injected to a position to be polished of the work piece 1 through a nozzle 62. As described above, the Si thin film 6 is surface ground by the free abrasive contained in the processing solution L and the polishing cloth 57. At this time, a mechanical vibration generated in the case of polishing is detected by the vibration sensor 64, and a vibration detection signal SV is output. FIG. 14 shows the vibration detection signal SV at this time. The vibration detection signal SV is amplified by the amplifier 65, then a vibration detection signal SF in which only a frequency band of 2kHz to 4kHz is extracted by a band-pass filter 66 is input to the vibration analyzer 67. The vibration detection signal SF input to the vibration analyzer 67 is FFT-processed by the vibration analyzer 67, and an analysis signal SA for indicating a power spectrum of the frequency band of, e.g., 2kHz to 4kHz is output to the process end point detector 68.

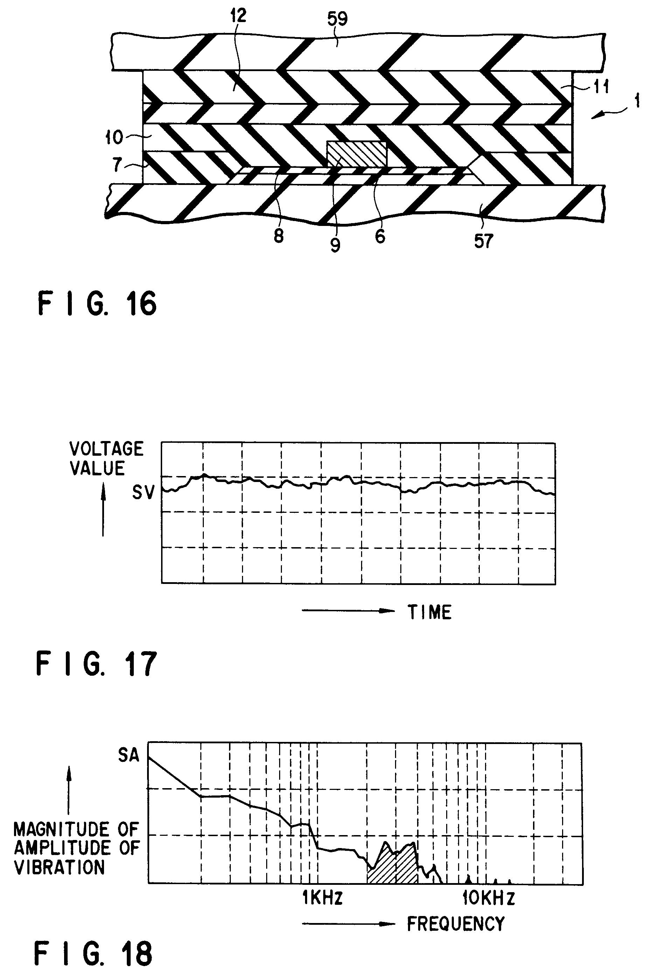

FIG. 15 shows the vibration detection signal SA at this time. In this case, since the vibration detection signal SA is smaller than a threshold value PT, the process stop signal SS is not output to the process control mechanism 61. Therefore, the polishing is continued as it is. Then, the polishing is advanced, and as shown in FIG. 16, the vibration detection signal SV in which the field oxide film 7 is exposed and contacted with the polishing cloth 17 is shown in FIG. 17. That is, as compared with FIG. 14 when only the Si thin film 6 is polished, a level is entirely raised, and its waveform is disordered. At this time, the analysis signal SA output from the vibration analyzer 67 becomes as shown in FIG. 18. That is, as compared with FIG. 15 when only the Si thin film 6 is polished, it is understood that a level of the frequency band of 2kHz to 4kHz is increased to a level exceeding the threshold value PT.

Therefore, when the analysis signal SA is input to the process end point detector 68, the analysis signal SA is larger than the threshold value PT, and hence the process stop signal SS is output to the process control mechanism 61. As a result, rotation stop signals SSU, SSD are applied from the process control mechanism 61 which inputs the process stop signal SS, and a rise signal SU is applied to the upper surface plate driving mechanism 60, thereby stopping polishing.

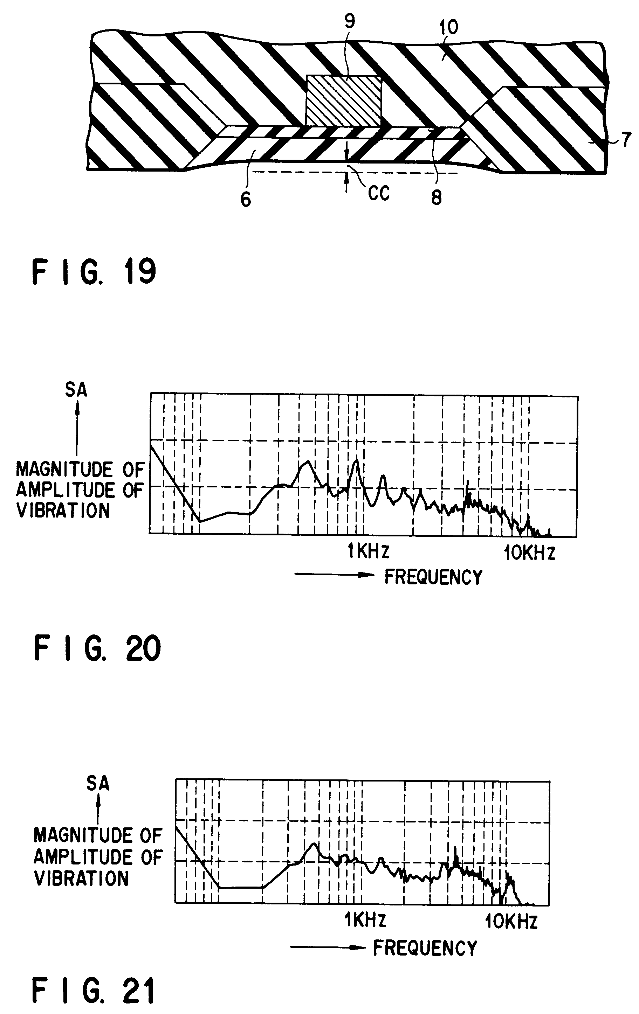

As described above, since the polishing apparatus of this embodiment has the process end point detecting unit 52, a sag a sag (recess) CC (see FIG. 19) of the field oxide film 7 can be reduced to 1 $\mu$m or less.

According to the method for polishing the work piece of this embodiment, since the detection of the end point of polishing is conducted and the polishing is stopped in view of the variation or change in the vibration mode or pattern of vibrating frequency generated during the polishing when polishing of the Si thin film 6 is shifted to that of the CVD-SiO$_2$ film 10, the sag (recess) of the opening 7a of the field oxide film 7 can be reduced to 1 $\mu$m or less.

In the polishing apparatus of the embodiment described above, the one vibration sensor 64 is mounted on the back surface of the upper surface plate 59. However, the present invention is not limited to the particular embodiment. For example, a plurality of vibration sensors 64 may be mounted, detections of process end points described above can be processed for the vibration detection signals SF from the respective vibration sensors 64, and their AND or OR operation may be eventually executed. Thus, the deciding accuracy of the detection of the end point can be improved. Further, in the embodiment described above, the vibration sensor 64 is mounted on the back surface of the upper surface plate 59. However, the vibration sensor 64 may be mounted on a bearing portion of the elevation means 60a, in case that the change in the vibrating pattern or resonance pattern is generated on the bearing portion. This method has an advantage that an expensive radio wave type may not be employed. Further, a vibration sensor 71 (FIG. 13) is mounted on the lower surface of the lower surface plate 56, and the above-described detection of the end point of processing may be conducted based on the vibration detection signal SF1 from the vibration sensor 71. Moreover, a difference between the vibration detection signal SF output from the vibration sensor 64 mounted on the upper surface plate 59 and the vibration detection signal SF1 output from the vibration sensor 71 mounted on the lower surface plate 56 is obtained, and the above-described detection of the end point of processing may be conducted based on a differential signal obtained therefrom. In addition, the vibration sensor 64 is mounted on the upper surface plate 59, a vibrator 72 is mounted on the lower, a mechanical vibration of a special frequency f of the degree not imparting influence to the processing is generated forcibly by the vibrator 72 during polishing, the vibration at this time is detected by the vibration sensor 64, and the detection of the end point of processing may be conducted based on the vibration detection signal SF extracted only in the frequency band including the above-described special frequency f by a band-pass filter. Thus, the deciding accuracy of the detection of the end point can be improved.

Further, in the embodiment described above, the vibration analyser 67 is provided between the band-pass filter 66 and the processing end point detector 68. However, the present invention is not limited to the particular embodiment. For example, the vibration analyzer 67 is omitted, and the detection of the end point is executed by a preset threshold value PT to the processing end point detector 68 for the vibration detection signal SF output from the band-pass filter 66. Moreover, in the embodiment described above, the detection of the end point of processing is conducted by comparing the threshold value PT with the analysis signal SA output from the vibration analyzer 67. However, an integrator is provided between the vibration analyzer 67 and the processing end point detector 68, and the detection of the end point of processing may be conducted by the threshold value by the processing end point detector 68 as to the integrated result of the analysis signal SA by the integrator.

On the other hand, according to the method for polishing the work piece of the embodiment described above, the detection of the end point of processing is executed by utilizing an increase in the amplitude of the frequency component in the power spectrum of the frequency band of, for example, 2 kHz to 4kHz when the field oxide film 7 is exposed and contacted with the polishing cloth 57. However, as shown in FIG. 20, the detection of the end point of processing may be executed by utilizing the fact that a peak value of the amplitude of the frequency component exists when only the Si thin film 6 is polished in the vicinity of 90 Hz of the power spectrum (this frequency is varied according to the structure of the apparatus) whereas the peak value is vanished (see FIG. 21) when the polishing is advanced, the field oxide film 7 is exposed and contacted with the polishing cloth 57.

Further, in the embodiment described above, as the type of processing, polishing is exemplified. However, any of lapping, grinding, surface grinding may be applied as the processing method. Of course, both the one side polishing or both side polishing may be applied.

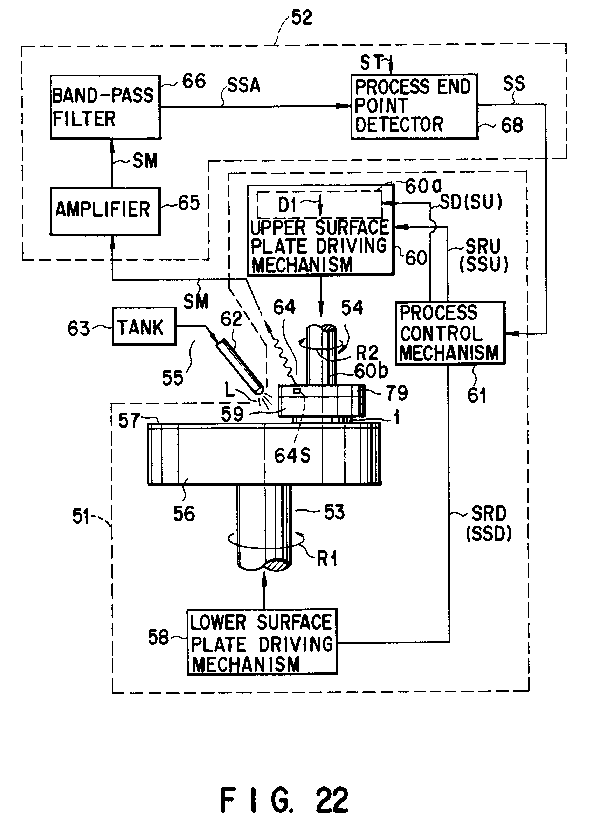

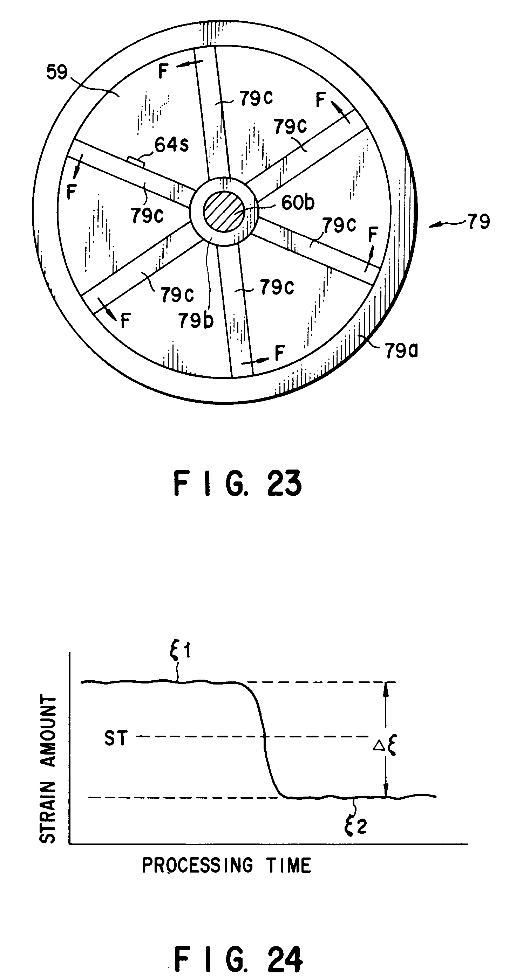

In addition, FIG. 22 shows a polishing apparatus according to still another embodiment of the present invention. Since the polishing apparatus has fundamentally the same structure as that of the polishing apparatus shown in FIG. 13, the same reference symbols as those in FIG. 13 are used to indicate the similar or corresponding structural components, and a description thereof will be omitted. More specifically, this polishing apparatus comprises a polishing unit 51 for surface grinding a thin plate-shaped work piece 1 to become an SOI, and a processing end point detector 52 for detecting an end point of processing the work piece 1 surface ground by the polishing unit 51. The polishing unit 51 has a lower surface plate section 53, an upper surface plate section 54 arranged at an upper position oppositely to the lower surface plate 53, and a process control mechanism 61 for electrically controlling the lower surface plate 53 and the upper surface plate 54. The polishing unit 51 of this embodiment is supplied with processing solution L from a liquid supply unit 55 to a position to be polished at the work piece 1. Further, the upper surface plate section 54 has an upper surface plate 59 having a diameter smaller than a radius of the lower surface plate 56, a wheel-shaped sensor mounting jig 79 (see FIG. 23) fixedly connected to the upper surface of the upper surface plate 59, and an upper surface plate driving mechanism 60 for holding the sensor mounting jig 79 and rotatably driving and applying a polishing pressure thereto.

The sensor mounting jig 79 has a ring-shaped outer wheel 79a, a circular tube-shaped bearing 79b provided at a concentric position of the center of the outer wheel 79a, and a rectangular-sectional submembers 79c radially and equidistantly bridged between the outer wheel 79a and the bearing 79b. A shaft 60b is engaged with the bearing 79b to be vertically moved up or down by the upper surface plate driving mechanism 60. The processing end point detector 52 has an amplifier 65 for amplifying a strain detection signal SM output from a strain gauge 64S attached to the sensor mounting jig 79, and a processing end point detector 68 for comparing to calculate the strain detection signal SM amplified by the amplifier 65 with a preset threshold value ST to output a process stop signal SS to the process control mechanism 61 when the threshold value ST is larger than the strain detection signal SM. The strain sensor 64S has a piezoelectric element as its body and mounted partly on the side of the submember 79c to transmit a signal to the amplifier 65 via a radio wave type and with antennas provided for transmitting and receiving the signal.

Then, a method for polishing a work piece by using the polishing apparatus as described above will be described.

The lower surface plate 56 is rotated, for example, in one direction of an arrow R1 at about 60 to 120 rpm, the upper surface plate 59 is rotated, for example, in a direction of an arrow R2 at about 60 to 120 rpm, moved down in a direction of an arrow D1, and an Si thin film 6 is contacted with a polishing cloth 57. As a result, a force F of a tangential direction is operated at the sensor mounting jig 79 through the work piece 1 and the upper surface plate 59. As a result, the submember 79c is deformed due to the force F. This strain is converted into a strain detection signal SM having a voltage value of the amplitude responsive to a strain amount by the strain sensor 64S. The strain detection signal SM is amplified by the amplifier 65, and compared with a preset threshold value ST by the process end point detector 68. Incidentally, as shown in FIG. 24, when only the Si thin film 6 is polished by free abrasive and the polishing cloth 57, a strain $\epsilon 1$, whereas when the polishing is advanced, the field oxide film 7 is exposed and started to be contacted with the polishing cloth 57, the strain becomes $\epsilon 2$ due to a reduction in its frictional resistance (which is considered that the field oxide film 7 is harder, scarcely ground and easily slid). That is, when it reaches the process end point, the strain is reduced by $\Delta\epsilon$. In this case, the threshold value ST is set to between the strains $\epsilon 1$ and the strain $\epsilon 2$, thereby detecting the process end point. More particularly, the strain $\epsilon 2$ at the time of the end point of processing is reduced as compared with the threshold value ST, and a process stop signal SS is output to the process control mechanism 61.

As described above, the polishing apparatus of this embodiment has the process end point detector 52 for detecting the end point of processing in view of the reduction in the strain of the rotating direction upon reduction of the frictional resistance generated at the time of the end point of processing. Therefore, a sag (recess) CC (see. FIG. 19) of the opening 7a of the field oxide film 7 can be set to 1 $\mu$m or less.

In the embodiments described above, the strain sensor 24S is mounted on the side face of the submember 79c. However, the present invention is not limited to the particular embodiment For example, as sown in FIG. 25, a cutout 79d is provided partly on the outer wheel 79a, and even if the strain sensor 64S is mounted on the cutout 79d, similar effect can be provided. Further, even if a pressure sensor is used instead of the strain sensor, the similar effect can be provided.

**Claims**

1.  A method for polishing a work piece (1, 41) having a plurality of types of materials laminated in a laminar state by polishing means (17, 57, L), comprising the following steps of:
    receiving a signal regarding a temperature at least from one of the work piece (1, 41) and the polishing means (17, 57) during polishing of the work piece (1);
    processing the received signal (SA);
    detecting a change point (T1, T2) of at least one temperature (T) of the work piece (1, 41) and the polishing means (17, 57) based on the processed signal; and
    detecting an end point of polishing based on the change points (T1, T2).

2. A method according to claim 1 further comprising the step of stopping polishing when an end point of polishing is detected.

3. A method according to claim 1, characterized in that said polishing means comprises a polishing cloth (17, 57), and said signal receiving step receives a signal regarding a temperature generated from the polishing cloth.

4. A method according to claim 1, characterized in that said signal receiving step is to receive a signal regarding a temperature directly or indirectly from a surface to become a rear side to the surface to be polished of the work piece (91, 41).

5. A method for polishing a work piece (41) having a plurality of layers containing at least two types of material layers laminated substantially in parallel to a flat surface parallel to the surface of the predetermined layer to be disposed at its outside, comprising the steps of:
   receiving a signal regarding a temperature at least from one of the work piece (1, 41) and the polishing means (17, 57) during surface grinding of the predetermined layer;
   processing the received signal (SA);
   detecting a temperature change based on the processed signal when the surface grinding is shifted from said special layer to an adjacent layer having a different material; and
   stopping the surface grinding when the temperature change is detected.

6. A method according to claim 5, characterized in that said work piece (1) comprises a first thin film portion (6) made of polycrystalline Si, and a second thin film portion (7) having an opening (7a) laminated on the first thin film portion (6), partly extended with a material of the first thin film portion and made of $SiO_2$, and said temperature change detecting step has a process for detecting at least a reduction in a temperature of one of the work piece (1, 41) and the polishing means (17, 57) when the surface grinding of said first thin film portion (6) is shifted to the surface grinding of said second thin film portion (7).

7. A method for polishing a work piece for surface grinding a portion of a special layer of the work piece having at least two types of materials made of a plurality of different type materials to be laminated in parallel parallel to the surface of said layer, comprising the steps of:

   receiving a signal regarding a temperature at least from one of the work piece (1, 41) and the polishing means (17, 57) during surface grinding of the predetermined layer;
   processing the received signal (SA);
   detecting a temperature change based on the processed signal when the surface grinding is shifted from said predetermined layer to an adjacent layer having a different material; and
   stopping the surface grinding when the temperature change is detected.

8. A method according to claim 5, characterized in that said temperature change detecting step has a process for detecting an increase in at least one temperature gradient of the work piece (1, 41) and the polishing means (17, 57) for the polishing time.

9. A polishing apparatus comprising:
   polishing unit (2) relatively moved to a work piece (1, 41) and having polishing means (17, 57) for polishing the work piece; and
   a temperature sensor (24) for detecting a surface temperature of the polishing means (17, 57), and a processor (26) for processing a signal for indicating a surface temperature of said polishing unit output from said temperature sensor (24, 30), and a process end point detector (3) for detecting an end point of polishing.

10. A polishing apparatus according to claim 9, characterized in that said polishing unit (2) comprises chuck means (19, 19a, 32) for detachably holding the work piece (1, 41), and a polishing cloth (17, 57) for polishing the work piece (1, 41).

11. A polishing apparatus according to claim 9, characterized in that said temperature sensor (24, 30) is an infrared light temperature sensor for detecting an infrared light and arranged at a position separate from the polishing cloth (17, 57) oppositely to the polishing cloth (17, 57).

12. A polishing apparatus according to claim 9, characterized in that said temperature sensor (30) is buried in chuck means (19) for detecting a temperature of the work piece (1, 41) held by said chuck means.

13. A method for polishing a work piece for surface grinding the work piece (1, 41) made of a plurality of types of materials, comprising the steps of:
   receiving an electric signal (SV) regarding a vibration of the work piece (1, 41) based on polishing during polishing of the work piece (1, 41);

processing the received signal (SV) to form a vibration signal detection signal (SF);

analyzing the vibration signal detection signal (SF) to output an analysis signal (SA);

detecting a cbage in a resonance pattern based on a material structural change of the work piece (1, 41) by using the analysis signal (SA); and

stopping the polishing when the change of the vibration mode is detected.

14. A method for polishing a work piece for surface grinding only a special layer of the work piece (1, 41) having a plurality of types of materials laminated parallel to said layer, comprising the steps of:

receiving an electric signal (SV) regarding a vibration of the work piece (1, 41) based on polishing during polishing of the work piece (1, 41);

processing the received signal (SV) to form a vibration signal detection signal (SF);

analyzing the vibration signal detection signal (SF) to output an analysis signal (SA);

detecting a variation in a vibration mode generated when surface grinding of said special layer is shifted to surface grinding of other layer by using the analysis signal (SA); and

stopping the polishing when the change of the vibration mode is detected.

15. A method for polishing a work piece (41) for surface grinding only a special layer of the work piece (1, 14) having at least two types of materials laminated parallel to the surface of said layer, comprising the steps of:

forming an electric signal (SM) corresponding to a strain of holding means (59, 79) for holding the work piece during polishing of said work piece (1, 41);

detecting a changer of a frictional resistance generated when surface grinding of the special layer is shifted to surface grinding of other layer based on a change of the electric signal (SM); and

stopping the polishing when the change of the frictional resistance is detected.

16. A polishing apparatus comprising:

polishing unit (51) for surface grinding a work piece (1, 41); and

a processing end point detector (52) for detecting a processing end point of the work piece (1, 41) surface ground by said polishing unit (51) to apply a polish stop signal (SS) to said polishing unit (51) based of the detected result;

said process end point detector (52) comprising:

a vibration sensor (64) provided in said polishing unit (51) for detecting a vibration generated when said work piece is polished by said polishing unit to output a vibration detection signal (SV);

a filter (66) receiving the vibration detection signal (SV) output from said vibration sensor (64) for extracting a special frequency band to output a vibration detection signal (SF); and

a process end point detector (68) for detecting a process end point based on the vibration detection signal (SF) extracted by said filter (66) to output a polish stop signal (SS).

17. A polishing apparatus according to claim 16, characterized in that said process end point detector (68) has a preset threshold value and compares the threshold value with the vibration detection signal (SF) output from said filter (66) to detect a process end point.

18. A polishing apparatus according to claim 16, further comprising:

a vibration analyzer (67) provided between said filter (66) and said process end point detector (68);

characterized in that said vibration analyzer (67) obtains a power spectrum at a predetermined time of the vibration detection signal (SF) output from said filter (66) to form an analysis signal (SA) indicating the power spectrum, said process end point detector (68) has a predetermined threshold value for comparing the analysis signal (SA) with the threshold value to detect the process end point.

19. A polishing apparatus comprising:

a polishing unit (51) having holding means (59) for holding a work piece (1, 41), and polishing means (56, 57) relatively moved to said holding means (59) for polishing the work piece (1, 41) to surface ground the work piece (1, 41); and

a process end point detector (52) for detecting a process end point of the work piece (1, 41) surface ground by said polishing unit (51) to apply a polish stop signal (SS) to said polishing unit (51) based on the detected result;

characterized in that said holding means (59) comprises strain means (79) to be deformed when the work piece (1, 41) is polished and strain detecting means (64S) for generating a signal responsive to the strain amount of the strain means (79); and

said process end point detector (52) comprises a process end point detector (68) for processing a strain detection signal (SM) output from said strain detecting means (64S) and detecting the process end point to output the polish stop signal (SS).

20. A polishing apparatus according to claim 19, characterized in that said polishing unit (51) comprises a lower surface plate (56) mounting with said polishing means (57) to be rotatably driven;

said holding means comprises an upper surface plate (59) provided oppositely to the lower surface plate (56) and fixed with said work piece (1, 41) to be rotatably driven; and

said strain means comprises a strain sensor (64S) having a sensor mounting jig (79) connected to the upper surface plate (59), said strain detecting means has a strain sensor (64S) mounted at said sensor mounting jig.

21. A polishing apparatus according to claim 20, characterized in that said sensor mounting jig (79) comprises a ring-shaped outer wheel (79a) and a plurality of submembers (79c) radially extended from the outer wheel toward a center, and connected coaxially with said upper surface plate (59).

22. A polishing apparatus according to claim 21, characterized in that said strain sensor (64S) is mounted at a submember (79S) of said sensor mounting jig (79).

23. A polishing apparatus according to claim 21, characterized in that said sensor mounting jig (79) comprises a cutout (79a) formed on the outer wheel (79a), and said strain sensor (64S) is mounted in the cutout (79d).

EP 0 616 362 A2

F I G.   1

14

F I G.  2

F I G.  4

START

S1

VACUUM-CHUCK WORK PIECE 1 TO UPPER SURFACE PLATE 19

S2a

APPLY ROTATION SIGNAL SRD TO LOWER SURFACE PLATE DRIVING MOTOR 18b FROM PROCESS CONTROL MECHANISM 21

S2b

APPLY ROTATION SIGNAL SRU TO UPPER SURFACE PLATE DRIVING MOTOR 20e FROM PROCESS CONTROL MECHANISM 21

S2c

APPLY LIQUID SUPPLY SIGNAL SL TO LIQUID SUPPLY U8NIT 15 FROM CONTROL MECHANISM 21

S2d

APPLY DOWN SIGNAL SD TO SOLENOID VALVE 20d FROM PROCESS CONTROL MECHANISM 21

S3a

ROTATE LOWER SURFACE PLATE 16 AT 60 ~ 120 RPM

S3b

ROTATE UPPER SURFACE PLATE 19 AT 90 ~ 120 RPM

S3c

INJECT POLISHING SOLUTION L TO WORK PIECE 1 THROUGH NOZZLE 22

S3d

MOVE DOWN UPPER SURFACE PLATE 19

S4

IS POLISHING PRESSURE 200 ~ 1600 FG / CM$^2$ ?

N

Y

1

FIG. 3A

EP 0 616 362 A2

DETECT SURFACE TEMPERATURE T OF POLISHING CLOTH 17 BY SENSOR 24 AND CONVERT IN INTO ELECTRIC SIGNAL ST — S5

AMPLIFY ELECTRIC SIGNAL ST BY AMPLIFIER 25 — S6

CALCULATE DIFFERENTIAL COEFFICIENT OF SURFACE TEMPERATURE T FOR POLISHING TIME t BY ARITHMETIC PROCESSOR 26 — S7

S8 — IS TEMPERATURE CHANGE POINT T1 TO BE SHIFTED FROM REGION R1 TO REGION 42 BY ARITHMETIC PROCESSOR 26 ? — N

Y

APPLY RISE SIGNAL SD1 TO SOLENOID VALVE 20d FROM CONTROL MECHANISM 21 — S9

S10 — IS POLISHING PRESSURE REDUCED BY 10~30% ? — N

Y

FIG. 3B

```
          ┌─2─┐
          └─▽─┘
```

S11 — IS TEMPERATURE
CHANGE POINT T2 TO BE
SHIFTED FROM REGION R1 TO REGION
43 DETECTED BY ARITHMETIC
PROCESSOR 26
?

N

Y

S12 — REVERSELY OPERATE PRESSURIZING MEANS 20c
AFTER SEVERAL MINUTES FROM DETECTING TIME
POINT (AFTER SURFACE TEMPERATURE T OF
POLISHING CLOTH 17 IS LOWERED)

S13a — APPLY ROTATION STOP
SIGNAL SSU TO UPPER
SURFACE PLATE DRIVING
MOTOR 20e FROM
CONTROL MECHANISM 21

S13b — APPLY ROTATION STOP
SIGNAL SD TO LOWER
SURFACE PLATE DRIVING
MOTOR 18b FROM
CONTROL MECHANISM 21

END

# F I G. 3C

EP 0 616 362 A2

F I G. 5

F I G. 6

F I G. 7

19

F I G. 8

F I G. 9

F I G. 10

F I G. 11

F I G. 12

# F I G. 13

VOLTAGE
VALUE

SV

→ TIME

F I G. 14

SA

MAGNITUDE OF
AMPLITUDE OF
VIBRATION

1KHZ          10KHZ

→ FREQUENCY

F I G. 15

23

F I G. 16

F I G. 17

F I G. 18

F I G. 19

F I G. 20

F I G. 21

25

F I G. 22

F I G. 23

F I G. 24

F I G. 25

F I G. 26